# EUROPÄISCHE PATENTSCHRIFT

(11) **EP 3 012 465 B1**
(45) Veröffentlichungstag und Bekanntmachung des Hinweises auf die Patenterteilung: **26.10.2016**
(21) Anmeldenummer: 15195514.3
(22) Anmeldetag: 21.05.2014
(51) Int. Cl.: F16B 5/12, F16B 19/10, F16B 21/08, F16B 2/24

(54) **BEFESTIGUNGSMITTEL**
ATTACHMENT DEVICE
MOYEN DE FIXATION

(30) Priorität: 15.07.2013 DE 202013006326 U; 15.07.2013 DE 202013006325 U; 24.08.2013 DE 202013007589 U; 17.02.2014 DE 202014001330 U
(43) Veröffentlichungstag der Anmeldung: 27.04.2016
(62) Teilanmeldung aus: 14744449.1
(73) Patentinhaber: BJB GmbH & Co. KG, 59755 Arnsberg (DE)
(72) Erfinder: Baumeister, Olaf, 59846 Sundern (DE); Beleke, Herbert, 59821 Arnsberg (DE)
(74) Vertreter: Ostriga Sonnet Wirths & Vorwerk

(56) Entgegenhaltungen:
- DE-A1-102004 025 698
- DE-A1-102010 035 012
- FR-A1- 2 928 428
- US-A1- 2006 086 765
- US-A1- 2011 116 890

## Beschreibung

Die Erfindung betrifft ein Befestigungsmittel mit einem Schaft; mit einem an einem Schaftende angeordneten Schaftkopf, wobei der Schaftkopf gegenüber dem Schaft im Durchmesser erweitert ist, wobei das Befestigungsmittel zur Anordnung zweier Bauteile aneinander vorgesehen ist, insbesondere zur Anordnung einer mit einer LED versehenen Leiterplatte an einem wärmeabführenden Leuchtenbauteil, indem der Schaft durch eine Durchbrechung eines ersten Bauteils hindurchführbar und der Schaftkopf zur zumindest mittelbaren Auflage auf dem ersten Bauteil vorgesehen ist und indem der Schaft in einer Ausnehmung eines zweiten Bauteils anordenbar ist und indem der Schaft zumindest reibschlüssig in der Ausnehmung des zweiten Bauteils verankerbar ist. Gattungsgemäße Befestigungsmittel sind der Anmelderin aus dem Stand der Technik der Beleuchtungstechnik nicht bekannt, jedoch zeigt die aus einem anderen Anwendungsgebiet stammende US 2011/0116890 A die Merkmale des Oberbegriffs von Anspruch 1.

Es existieren jedoch ähnliche Befestigungsmittel in der Automobilindustrie, die dort als Spreizniet bezeichnet werden. So ist ein ähnliches Befestigungsmittel beispielsweise aus der gattungsfremden WO 2005/071273 A1 bekannt. Dieser Spreizniet wird im Bereich der Automobilindustrie in der Regel dafür verwendet, Innenverkleidungsteile an der Karosserie festzulegen.

In der Beleuchtungstechnik werden zunehmend LEDs als Lichtquelle benutzt. LEDs sind üblicherweise auf einer Platine angeordnet, die im Regelfalle eine gute Wärmeleitung aufweist. Auf der Oberseite der Platine befinden sich Leiterbahnen, um die LEDs elektrisch auszuschließen. Diese Leiterbahnen müssen gegenüber Metallteilen beabstandet oder isoliert sein. Diese Platinen werden auf einem Gegenlager befestigt, welches beispielsweise als Kühlkörper ausgebildet ist und ein Leuchtenbauteil darstellt oder Teil des Leuchtengehäuses selbst ist. Bei der Montage der Platine auf dem Leuchtenbauteil kommt dem korrekt gewählten Anlagedruck eine hohe Bedeutung zu, da dieser maßgeblicher Faktor für die Qualität der Wärmeabfuhr von der LED auf das Leuchtenbauteil ist.

Ein Befestigungselement, welches einzelne mit LEDs versehene Platinen auf einem Leuchtenbauteil festlegt, ist beispielsweise aus DE 10 2008 005 823 A1 bekannt. Hier wird ein ringförmiges Anschlusselement auf der Platine aufgesetzt und lagert die Platine zwischen sich und einem Gegenlager, beispielsweise einem Kühlkörper. Über Schrauben wird dieses Anschlusselement mit dem Gegenlager verbunden. Das Anzugsmoment der Schrauben definiert die Andruckkraft zwischen Platine und Gegenlager.

Die zunehmende Massenfertigung von LED Leuchten verschiedenster Art erfordert Befestigungsmittel für die mit LED versehenen Platinen, die sich in automatisierten Fertigungsverfahren verwenden lassen. Dabei werden an solche Befestigungsmittel hohe Anforderungen an die dauerhafte Halterung der Platine und dauerhafte Aufrechterhaltung des Anlagedrucks gestellt, was in der prognostizierten Lebensdauer von bis zu 50.000 Stunden einer LED Lichtquelle begründet liegt.

Es ist insoweit Aufgabe der Erfindung, ein für die automatisierte Fertigung von Leuchten geeignetes Befestigungselement bereit zu stellen, welches einen definierten Anlagedruck zwischen LED und Leuchtenbauteil sicherstellt.

Gelöst wird die Aufgabe der Erfindung von einem Befestigungselement mit den Merkmalen des Anspruches 1, insbesondere mit dessen kennzeichnenden Merkmalen, wonach das Befestigungsmittel mit einem Isolierelement versehen, welches zwischen dem Schaftkopf und dem ersten Bauteil angeordnet, eine Berührung von Schaftkopf und erstem Bauteil verhindert und dass das Befestigungsmittel mit einem Spannelement versehen ist, welches über den Schaftkopf das erste Bauteil gegen das zweite Bauteil spannt.

Der wesentliche Vorteil des erfindungsgemäßen Befestigungsmittels liegt zunächst in seiner Eignung für die automatisierte Montage. Zwei Bauteile - das erste Bauteil entspricht der Platine mit LED, das zweite Bauteil entspricht dem Leuchtenbauteil - werden mit Durchbrechung und Ausnehmung fluchtend aufeinander angeordnet. Der Schaft des Befestigungsmittels wird durch die Durchbrechung hindurch in die Ausnehmung eingesetzt, bis der Schaftkopf auf dem ersten Bauteil aufliegt. Der Reibschluss des Schaftes legt das Befestigungsmittel in der Ausnehmung des zweiten Bauteils fest, so dass die Bauteile aufeinander fest angeordnet sind.

Die hierfür erforderlichen Montageautomaten und Montageverfahren sind einfach konzipier- und umsetzbar. Durch das kennzeichnende Merkmal des Isolierelementes wird verhindert, dass das Befestigungsmittel mit der Oberfläche der Platine und den darauf befindlichen Leiterbahnen in Berührung kommt und diese möglicherweise mechanisch beschädigt oder, im Falle metallischer Befestigungsmittel, kurzschließt. Das Spannelement sorgt für das Aufbringen einer Andruckkraft zwischen erstem und zweitem Leuchtenbauteil, so dass ein guter Wärmeübergang von der LED zum Leuchtenbauteil gegeben ist.

Es ist vorgesehen, dass das Isoliermittel aus einem elektrisch nicht leitfähigen Material besteht, insbesondere da das Befestigungsmittel selbst aus Metall gefertigt ist.

Die Ausführung des Befestigungsmittels aus Metall ist außerordentlich bevorzugt, da ein metallenes Befestigungsmittel den Befestigungskräften auch über Jahre hinweg standhält. So ist es im Gegensatz dazu von Kunststoffteilen bekannt, dass diese sich unter Krafteinwirkung über den Zeitablauf verformen und so den auf sie wirkenden Kräften ausweichen. Dies birgt insbesondere bei der hohen Lebenserwartung der LEDs die Gefahr, dass die Befestigungsfunktion nicht durchgehend erfüllt wird.

Es kann vorgesehen sein, dass das Isolierelement aus einem rückstellelastischen Material besteht und als Spannelement dient.

Der wesentliche Vorteil dieser Ausführungsform liegt darin, dass die Anzahl der Bauelemente reduziert wird. Da das Isolierelement ohnehin zwischen Schaftkopf und erstem Bauteil angeordnet ist, kann es über die in Einschubwirkung gerichteten Montagekräfte bei der Festlegung des Befestigungsmittels mit einer entsprechenden Spannkraft beaufschlagt werden, so dass die Rückstellkräfte des Isolierelement sich am Schaftkopf einerseits und am ersten Bauteil andererseits abstützen. Hierdurch wird die Andruckkraft zwischen erstem und zweitem Bauteil induziert.

Unter diesen Bedingungen erhält die Ausführung des Befestigungselementes aus Metall eine besonders hohe Bedeutung, da das Befestigungsmittel selbst vom Spannelement mit einer Kraft beaufschlagt wird.

Bei einer besonders bevorzugten Ausführungsform ist vorgesehen, dass der Schaft durchmessererweiternde Halteteile aufweist - insbesondere Rasthaken -, die eine Formschlussverbindung mit dem zweiten Bauteil eingehen können.

Insbesondere, wenn das Befestigungsmittel durch die Ausbildung des Isoliermittels als Spannelement mit am Aufbau der Andruckkraft beteiligt ist, ist eine Formschlussverbindung zu bevorzugen. Diese stellt im Gegensatz zu einer Reibschlussverbindung in hohem Maße ein sicheres Einsitzen des Befestigungsmittels in der Ausnehmung des zweiten Bauteils sicher.

Es ist vorgesehen, dass das Isolierelement eine Durchtrittsöffnung aufweist, durch welche der Schaft des Befestigungsmittels geführt ist. Die Durchtrittsöffnung erlaubt es, das Isolierelement scheibenartig zur Unterlage unter dem Schaftkopf vorzusehen und dennoch den Schaft selbst zur Befestigung der Bauteile nutzen zu können.

In einer Ausführungsform ist vorgesehen, dass der Schaft von zwei Schaftflügeln gebildet ist, die zwischen sich einen Zwischenraum bilden.

Weiterhin ist vorgesehen, dass das freie Ende wenigstens eines Schaftflügels ein Stützelement trägt, welches sich am anderen Schaftflügel abstützt und beide Schaftflügel in einer starren, voneinander beabstandeten Stellung hält.

Eine weitere Weiterbildung sieht vor, dass beide Schaftflügel jeweils ein Stützelement tragen und sich die Stützelemente aneinander abstützen.

Vor dem Hintergrund der gestellten Aufgabe betrifft die Erfindung auch eine Anordnung von einem Befestigungsmittel nach einem der Ansprüche 1 bis 9, einem ersten Bauteil und einem zweiten Bauteil, wobei der Schaftkopf auf einem Isolierelement, das Isolierelement auf dem ersten Bauteil und das erste Bauteil auf dem zweiten Bauteil aufliegt.

Diese Anordnung löst die erfindungsgemäße Aufgabe dadurch, dass ein Spannelement sich am Schaftkopf abstützt und eine gegenseitige Andruckkraft zwischen dem ersten und dem zweiten Bauteil aufbringt.

In einer ersten Ausführungsform ist vorgesehen, dass das Isolierelement vom Befestigungsmittel gegen das erste Bauteil verspannt ist und die so induzierte Rückstellkraft die Andruckkraft zwischen dem ersten und dem zweiten Bauteil aufbringt.

Die Erfindung wird im Folgenden an Hand der Darstellung eines Ausführungsbeispieles näher erläutert.

Es zeigen:
Fig. 1 ein erfindungsgemäßes Befestigungsmittel mit Halteklammer, Isolier- und Spannelement in Explosionsdarstellung,
Fig. 2 die bauliche Einheit des Befestigungsmittels aus Halteklammer, Isolier- und Spannelement in perspektivischer Ansicht,
Fig. 3 die bauliche Einheit gemäß Figur 2 in Ansicht von oben,
Fig. 4 die bauliche Einheit gemäß Figur 2 in einer ersten Seitenansicht,
Fig. 5 die bauliche Einheit gemäß Figur 2 in einer zweiten Seitenansicht,
Fig. 6 die Darstellung gemäß Figur 3 in Montagesituation,
Fig. 7 eine Schnittdarstellung gemäß Schnittlinie A-A in Figur 6,
Fig. 8 eine Darstellung der baulichen Einheit gemäß Figur 2 in Montagesituation in perspektivischer Ansicht unter schematischer Darstellung eines Zangenkopfes,
Fig. 9 die Darstellung gemäß Figur 4 der baulichen Einheit in Montagesituation,
Fig. 10 eine Schnittdarstellung gemäß Schnittlinie B-B in Figur 9.

Ein erfindungsgemäßes Befestigungsmittel ist in den Figuren insgesamt mit der Bezugsziffer 110 versehen.

Das Befestigungsmittel 110 umfasst zunächst eine Halteklammer 111, die einen Schaft 112 aufweist, der von zwei Schaftflügeln 113 gebildet ist. Die Schaftflügel 113 weisen ein freies Ende 114 auf und sind mit einem angebundenen Ende 115 jeweils an einem Schaftkopf 116 befestigt.

Die Schaftflügel 113 sind zueinander beabstandet und weisen zwischen sich einen Zwischenraum 117 auf. Die freien Enden 114 verjüngen sich und bilden auf diese Weise Einführstümpfe 118, mit denen voran das Befestigungsmittel 110 zu montieren ist. Den Einführstümpfen 118 in Richtung Schaftkopf 116 nachgeordnet bildet jeder Schaftflügel 113 Halteteile 119 aus, bei denen es sich vorliegend um Rasthaken 120 handelt, die nach außen - d.h. vom Zwischenraum 117 weg - weisen. Ein sich daran wiederum in Richtung Schaftkopf 116 nachordnender Schafthals 121 geht in einen Schaftlöseabschnitt 122 über, in den ein ebenfalls nach außen gerichteter Lösenocken 123 eingeprägt ist.

Der Schaftkopf 116 ist in etwa scheibenartig ausgebildet und spannt eine Ebene auf, zu der die Schaftflügel 113 im Wesentlichen orthogonal gerichtet sind. Ein gedachter innerer Radius r des Schaftkopfes 116 entspricht in etwa dem Radius einer Durchbrechung 138 in einem ersten Bauteil 133 und einer Ausnehmung 139 in einem zweiten Bauteil 134, in welche der Schaft 112 des Befestigungsmittels 110 einzusetzen ist. In Folge dessen liegen die Schaftflügel 113 auf diesem Radius r.

Im Bereich der Anbindung der Schaftflügel 113 an den Schaftkopf 116 weist der Schaftkopf 116 deshalb Rücksprünge auf, die sich als Eingriffsausnehmungen 124 darstellen. In diesen Bereichen verjüngt sich der Schaftkopf von einem äußeren Radius R bis auf den inneren Radius r. Teil des Befestigungsmittels 110 ist darüber hinaus ein Isolierelement 130. Dieses ist bei dem hier beschriebenen ersten Ausführungsbeispiel in etwa ring- bzw. ringscheibenförmig gestaltet. Der Ringinnenraum ist als Durchtrittsöffnung 143 gestaltet.

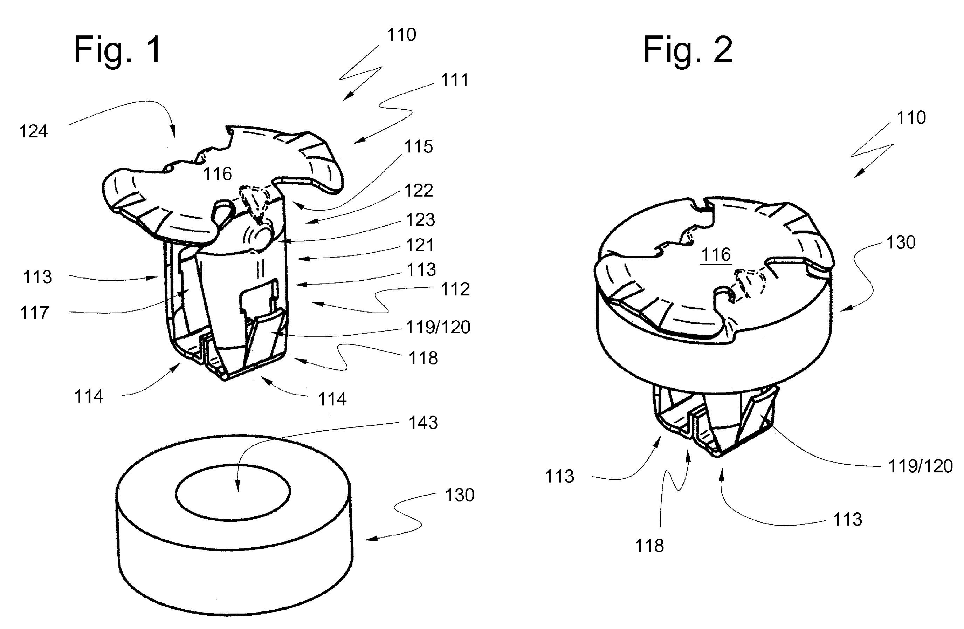

Wie insbesondere aus den Figuren 2, 4 und 5 zu sehen ist, ist das Isolierelement 130 dafür vorgesehen, unter dem Schaftkopf 116 angeordnet zu werden. Hierzu werden die Schaftflügel 113 durch die Durchtrittsöffnung 143 hindurchgeschoben, bis das Isolierelement 130 an der Unterseite des Schaftkopfes 116 anliegt.

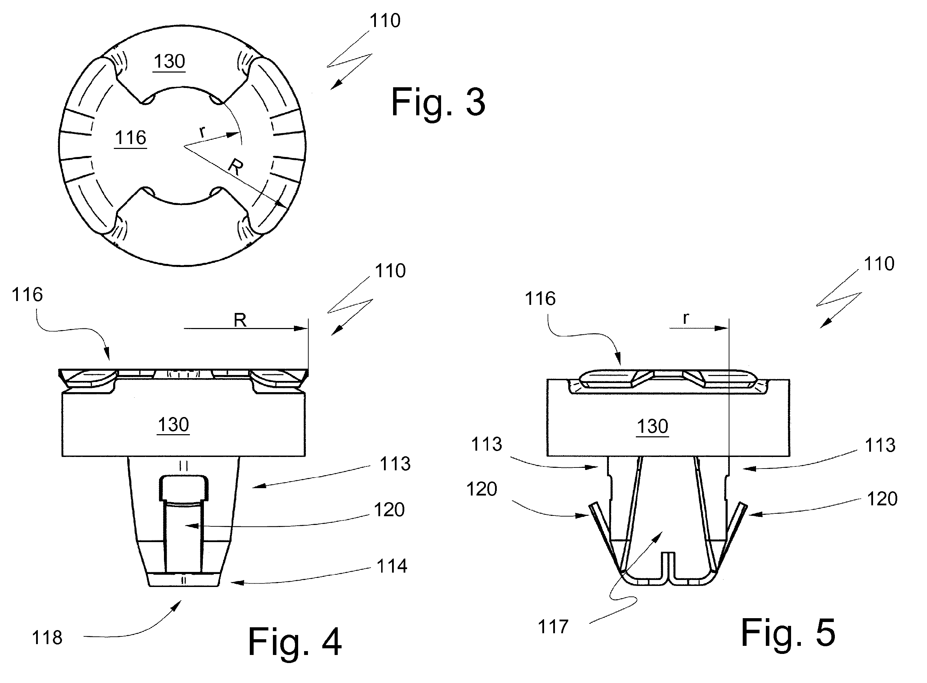

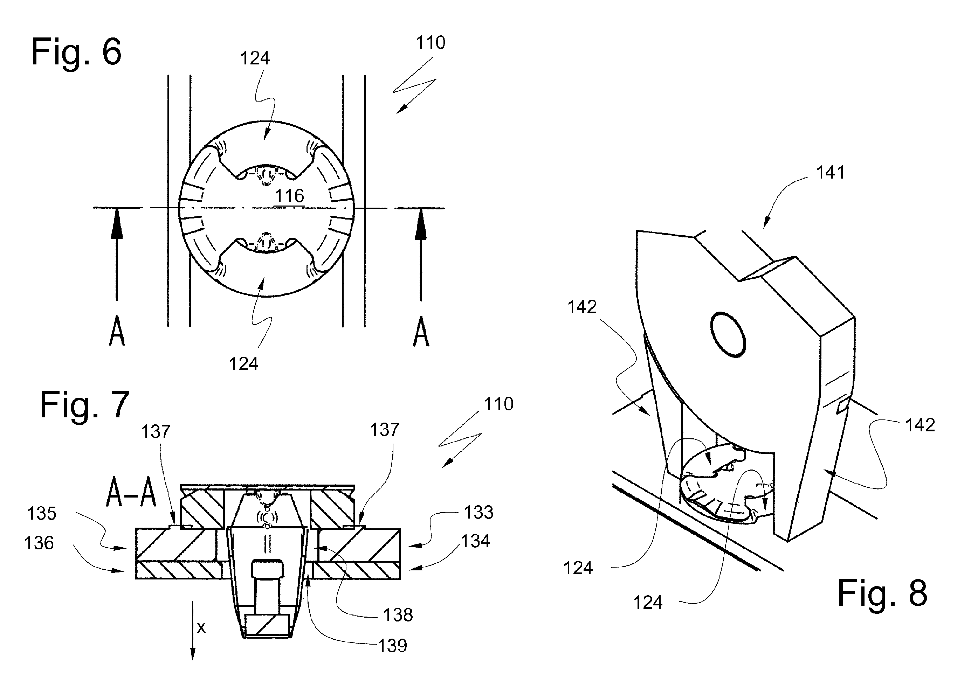

Wie aus den Figuren 3, 4 und 5 hervorgeht, liegt die Unterseite des Schaftkopfes 116 auf der Oberseite des Isolierelementes 130 auf, wohingegen die Unterseite des Isolierelementes 130 zur Auflage auf dem ersten Bauteil 133 vorgesehen ist (Fig. 7). Figur 5 zeigt überdies, dass die Schaftflügel 113 an ihren freien Enden 114 nach innen ungeformt sind und jeweils zueinander weisende und sich aneinander abstützende Stützelemente 126 tragen. Diese halten die Schaltflügel 113 starr in ihrer Normalstellung, in welcher die Rasthaken 120 über den inneren Radius r umfangserweiternd vorstehen.

Schließlich sei noch darauf hingewiesen, dass die Halteklammer 111 bevorzugter Weise aus einem Metallblech im Wege eines Stanzbiegeprozesses hergestellt ist. Das Isolierelement 130 besteht aus einem elektrisch nicht leitenden Material und ist aus einem rückstellelastischen Material gebildet. Eine bevorzugte Ausführung sieht vor, das Isolierelement 130 aus Silikon zu fertigen. Andere rückstellelastische Kunststoffe sind jedoch auch geeignet.

Figur 7 zeigt eine Schnittansicht des Befestigungsmittels 110 in einer Einbausituation entsprechend der Schnittlinie A-A in Figur 6. Zu sehen ist zunächst ein erstes Bauteil 133, welches auf einem zweiten Bauteil 134 aufliegt. Bei dem ersten Bauteil 133 handelt es sich in der Regel um eine Leiterplatte 135, das zweite Bauteil 134 ist in der Regel ein Leuchtenbauteil 136. Die Leiterplatte 135 mit Leiterbahnen 137 versehen, die der Elektrizitäts- oder Signalversorgung von nicht dargestellten LEDs dienen, die auf der Leiterplatte 135 angeordnet sind. Die Leiterplatte 135 ist mit einer Durchbrechung 138 versehen, das Leuchtenbauteil 136 weist eine Ausnehmung 139 auf. Anzumerken ist, dass die Durchbrechung 138 im ersten Bauteil 133 zwingend als Durchbrechung 138 über die gesamte Materialstärke ausgebildet sein muss. Die Ausnehmung 139 des zweiten Bauteils 134 ist im hier dargestellten Ausführungsbeispiel ebenfalls als eine das Material über seine gesamte Stärke durchsetzende Bohrung ausgebildet. Die Ausnehmung 139 des zweiten Bauteils 134 kann jedoch durchaus auch sacklochartig ausgestaltet sein. Durchbrechung 138 und Ausnehmung 139 fluchten miteinander.

Um das erste Bauteile 133 und das zweite Bauteil 134 miteinander zu verbinden, werden beide - wie in Figur 7 dargestellt - mit Durchbrechung 138 und 139 fluchtend aufeinander angeordnet. Sodann wird die gemäß Fig. 2 zum erfindungsgemäßen Befestigungsmittel mit 110 vormontierte Einheit aus Halteklammer 111 und Isolierelement 130 in Einschubrichtung X durch die Durchbrechung 138 hindurch in die Ausnehmung 139 eingesetzt. Dabei wird das Befestigungsmittel 110 mit dem freien Ende 114 des Schafts 112, insbesondere mit den Einführstümpfen 118 der Schaftflügel 113 voran in die Durchbrechung 138/ Ausnehmung 139 eingeschoben. Schließlich kommt es zur Auflage des Isolierelementes 130 auf der mit Leiterbahnen 137 versehenen Oberfläche der Leiterplatte 135.

Der Durchmesser der Durchbrechung 138 entspricht wenigstens dem inneren Radius r und ist kleiner als der äußere Radius R des Schaftkopfes 16. Die Ausnehmung 139 entspricht in etwa dem inneren Radius r, um eine sichere Verankerung der Rasthaken 20 zu gewährleisten.

Beim Einschieben des Befestigungsmittels 110 in Richtung X gleiten die über den inneren Radius r durchmessererweiternd vorstehenden Rasthaken 120 an den Kanten von Durchbrechung 138 und Ausnehmung 139 ab. Da sich die Rastflügel 113 starr aneinander abstützen, werden die Rasthaken 120 rückstellelastisch in Richtung Innenraum 117 verlagert.

Bei Auflage des Isolierelementes 130 auf der Oberfläche der Leiterplatte 135 ist die zur Verankerung beider Bauteile 133/134 miteinander notwendige Einschubbewegung in Richtung X noch nicht vollendet. Die Rasthaken 120 haben zumindest die Ausnehmung 139 des zweiten Bauteils 134 noch nicht abschließend durchstoßen. Hierzu ist die Fortsetzung der Einschubbewegung in Richtung X erforderlich, wobei ein das Isolierelement 130 komprimierender Einschubdruck auf den Schaftkopf 116 ausgeübt wird. Hierbei werden vom rückstellelastisch ausgebildeten Isolierelement 130 Rückstellkräfte gegen den Einschubdruck aufgebaut. Nunmehr durchstoßen die Rasthaken 120 die Ausnehmung 139 und hinterrasten an deren Unterseite, indem die Rückstellkräfte Rasthaken 120 zurückverlagern.

Die gegen den Einschubdruck wirkenden Rückstellkräfte des Isolierelementes 130 bleiben hingegen erhalten und führen zu einer Verspannung der Bauteile 133 und 134 gegeneinander, wobei die Rasthaken 120 einerseits und der Schaftkopf 116 andererseits als Widerlager dienen, gegen die die Rückstellkräfte des Isolierelementes 130 wirken. Auf diese Weise wird ein exakt definierbarer Anpressdruck bzw. eine exakt definierbar Andruckkraft zwischen den aneinander anliegenden Flächen des ersten und zweiten Bauteils 133/134 erzeugt. Insoweit ist aus der vorangegangen Funktionsbeschreibung ersichtlich geworden, dass das Isolierelement 130 auch als Spannelement 140 dient.

Die Erzeugung einer definierten Andruckkraft zwischen ersten und zweiten Bauteil 133/134 ist für die Funktion des erfindungsgemäßen Befestigungsmittels 110 von erheblicher Bedeutung, da dieses insbesondere für die Befestigung von mit LEDs bestückten Platinen an wärmeabführenden Leuchtenbauteilen 136 vorgesehen ist. Die die Lebensdauer der LED erheblich beeinflussende und deshalb notwendige Wärmeabfuhr von der Leiterplatte 135 an das Leuchtenbauteil 136 wird in erheblichen Maße von einem korrekten Anlagendruck zwischen dem ersten Bauteil 133 und dem zweiten Bauteil 134 beeinflusst.

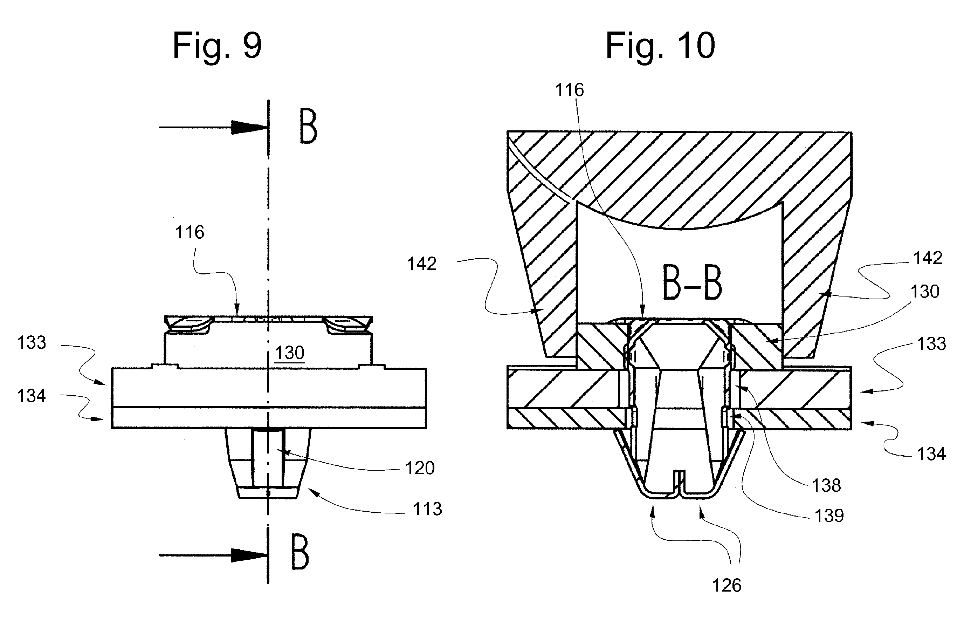

Es ist jedoch auch vorgesehen, dass Befestigungsmittel 110 wieder lösen zu können, um die Bauteile 133 und 134 voneinander zu trennen. Zu diesem Zweck weist die Halteklammer 111 die in Figur 1 und 3 gut erkennbaren und weiter oben kurz beschriebenen Eingriffsausnehmungen 124 auf, welche Raum für eine Zange bieten. In Figur 8 ist eine perspektivischer Ansicht eines montierten und die Bauteile 133 und 134 miteinander verbindenden Befestigungsmittels 110 in perspektivischer Ansicht gezeigt. Schematisch dargestellt ist ein Zangenkopf 141, dessen Zangenbacken 142 im Bereich der Angriffsausnehmungen 124 an freiliegenden Abschnitten des Isolierelementes 130 angeordnet sind. Figur 10 zeigt eine Schnittdarstellung des die Bauteile 133 und 134 aneinander festlegenden Befestigungsmittels 110 gemäß Schnittlinie B-B in Figur 19. Figur 10 zeigt darüber hinaus die Zangenbacken 142, die in Figur 9 der Übersicht halber weggelassen sind.

In Figur 10 ist deutlich sichtbar, dass die Rasthaken 120 die Unterseite des zweiten Bauteils 134 untergreifen und so beide Bauteile 133/134 zwischen dem Isolierelement 130 und den Rasthaken 120 miteinander verbunden angeordnet sind. Die Zangenbacken 142 liegen mit ihren einander zugewandten Wirkflächen an den freiliegenden Abschnitten des Isolierelementes 130 an. Ein Schließen der Zange führt dazu, dass die Zangenbacken 142 aufeinander zu bewegt werden. In Folge dessen wird über die Zwischenlage des Isolierelementes 130 eine Kraft auf die Lösenocken 123 ausgeübt, die zu einer Verlagerung der Schaftflügel 113 im Bereich der Rasthaken 120 in den Zwischenraum 117 führt. Die Schaftflügel 113 werden hierbei rückstellelastisch verformt und bauen wiederum Rückstellkräfte auf, die der Verlagerungsrichtung der Schaftflügel 113 entgegenwirken. Sobald die Schaftflügel 113 ausreichend aufeinander zu bewegt wurden, lässt sich das Befestigungsmittel 110 mittels der Zange entgegen der Einsetzrichtung X aus der Ausnehmung 139 und Durchbrechung 138 herausziehen, so dass das erste Bauteil 133 und das zweite Bauteil 134 voneinander trennbar sind.

Zur erwähnen ist noch, dass die Halteklammer 111 in außerordentlich bevorzugter Ausführungsform aus einem Metall gebildet ist. Das Isolierelement 130 ist in bevorzugter Weise aus einem rückstellelastischen Silikon gebildet. Die Wahl als Metall als Material für die Halteklammer 111 hat den wesentlichen Vorteil, dass es den vom Isolierelement 130 aufgebrachten Rückstellkräften standhält, wohingegen bei Kunststoff in der Regel die Gefahr besteht, dass dieser mit der Zeit den Rückstellkräften nachgibt. Dies kann zu einem Lösen der Verbindung zwischen dem ersten und dem zweiten Bauteil 133/134 führen, hat in jedem Fall jedoch zur Folge, dass sich die Andruckkraft zwischen beiden Bauteilen 133/134 vermindert, was zu einem verminderten Wärmeübergang führt.

### Bezugszeichenliste:

- 110: Befestigungsmittel
- 111: Halteklammer
- 112: Schaft
- 113: Schaftflügel
- 114: freies Ende
- 115: angebundenes Ende
- 116: Schaftkopf
- 117: Zwischenraum
- 118: Einführspitze
- 119: Halteteil
- 120: Rasthaken
- 121: Schafthals
- 122: Schaftlöseabschnitt
- 123: Lösenocken
- 124: Eingriffsausnehmung
- 126: Federschenkel / Federsteg
- 130: Isolierelement
- 133: erstes Bauteil
- 134: zweites Bauteil
- 135: Leiterplatte
- 136: Leuchtenbauteil
- 137: Leiterbahn
- 138: Durchbrechung
- 139: Ausnehmung
- 141: Zangenkopf
- 142: Zangenbacken
- 143: Durchtrittsöffnung
- X: Einsetzrichtung
- r: innerer Radius
- R: äußerer Radius

## Patentansprüche

1. Befestigungsmittel (110)
- mit einem Schaft (112);
- mit einem an einem Schaftende angeordneten Schaftkopf (116),
- wobei der Schaftkopf (116) gegenüber dem Schaft (112) im Durchmesser erweitert ist,
- wobei das Befestigungsmittel (110) zur Anordnung zweier Bauteile (133, 134) aneinander vorgesehen ist, insbesondere zur Anordnung einer mit einer LED versehenen Leiterplatte (135) an einem wärmeabführenden Leuchtenbauteil (136),
- indem der Schaft (112) durch eine Durchbrechung (138) eines ersten Bauteils (133) hindurchführbar und der Schaftkopf (116) zur zumindest mittelbaren Auflage auf dem ersten Bauteil (133) vorgesehen ist
- und indem der Schaft (112) in einer Ausnehmung (139) eines zweiten Bauteils (134) anordenbar ist
- und indem der Schaft (112) zumindest reibschlüssig in der Ausnehmung (139) des zweiten Bauteils (134) verankerbar ist, **dadurch gekennzeichnet, dass**
- das Befestigungsmittel (110) mit einem Isolierelement (130) versehen ist, welches zur Anordnung zwischen dem Schaftkopf (116) und dem ersten Bauteil (133) vorgesehen ist und geeignet ist, eine Berührung von Schaftkopf (116) und erstem Bauteil (133) zu verhindern,
- dass das Befestigungsmittel (110) mit einem Spannelement versehen ist, welches geeignet ist, über den Schaftkopf (116) das erste Bauteil (133) gegen das zweite Bauteil (134) zu spannen,
- das Isolierelement aus einem rückstellelastischen Material besteht und als Spannelement dient,
- der Schaft (112) durchmessererweiternde Halteteile in Form von Rasthaken (120) aufweist, die eine Formschlussverbindung mit dem zweiten Bauteil (134) eingehen können,
- das freie Ende (114) wenigstens eines Schaftflügels (113) umgeformt ist und ein Stützelement ausbildet, welches sich am anderen Schaftflügel (113) abstützt,
- das Stützelement hält die Schaltflügel (113) starr in einer Normalstellung, in welcher die Rasthaken 120 über einen inneren Radius r umfangserweiternd vorstehen.

2. Befestigungsmittel (110) nach Anspruch 1, **dadurch gekennzeichnet, dass** das Isolierelement aus einem elektrisch nicht leitfähigen Material besteht.

3. Befestigungsmittel (110) nach Anspruch 1 oder 2, **dadurch gekennzeichnet, dass** das Befestigungsmittel (110) aus Metall gefertigt ist.

4. Befestigungsmittel (110) nach einem der vorhergehenden Ansprüche, **dadurch gekennzeichnet, dass** das Isolierelement (130) eine Durchtrittsöffnung aufweist, durch welche der Schaft (112) des Befestigungsmittels (110) geführt ist.

5. Befestigungsmittel (110) nach einem der vorhergehenden Ansprüche, **dadurch gekennzeichnet, dass** der Schaft (112) von zwei parallelen Schaftflügeln (113) gebildet ist.

6. Befestigungsmittel (110) nach Anspruch 1, **dadurch gekennzeichnet, dass** beide Schaftflügel (113) jeweils ein Stützelement tragen und sich die Stützelemente aneinander abstützen.

7. Anordnung von einem Befestigungsmittel (110) nach einem der Ansprüche 1 bis 6, einem ersten Bauteil (133) und einem zweiten Bauteil (134), wobei der Schaftkopf (116) auf einem Isolierelement (130), das Isolierelement (130) auf dem ersten Bauteil (133) und das erste Bauteil (133) auf dem zweiten Bauteil (134) aufliegt, **dadurch gekennzeichnet, dass** ein Spannelement (140) sich am Schaftkopf (116) abstützt und eine gegenseitige Andruckkraft zwischen dem ersten und dem zweiten Bauteil 133,134) aufbringt.

8. Anordnung nach Anspruch 7 unter Nutzung eines Befestigungsmittels (110) nach Anspruch 1, **dadurch gekennzeichnet, dass** das Isolierelement 130) vom Befestigungsmittel (110) gegen das erste Bauteil (133) verspannt ist und die so induzierte Rückstellkraft die Andruckkraft zwischen dem ersten und dem zweiten Bauteil (133, 134) aufbringt.

9. Verfahren zur Anordnung zweier Bauteile (133, 134) aneinander, wobei das erste Bauteil (133) eine Durchbrechung (138) aufweist und das zweite Bauteil (134) mit einer Ausnehmung (139) versehen ist, mittels eines Befestigungselementes gemäß einem der Ansprüche 1 bis 6 mit den folgenden Verfahrensschritten:
a) Anordnung der Bauteile (133, 134) aufeinander, wobei die Durchbrechung (138) und die Ausnehmung (139) miteinander fluchten.
b) Einsetzen des aus Halteklammer (111) und Isolierelement (130) zusammengesetzten Befestigungsmittels (110) in Einschubrichtung (x) durch die Durchbrechung (138) mit seinem freien Schaftende (114) voran in die Ausnehmung (139) bis zur Auflage des Isolierelementes (130) auf dem ersten Bauteil (130) kommt.
c) Abgleiten der Rasthaken (120) an Kanten von Durchbrechung (138) und Ausnehmung (139) und rückstellelastische Verlagerung der Rasthaken (120) in einen Innenraum (117) des Befestigungselementes (110).
d) Fortsetzen der Einschubbewegung in Einschubrichtung (x) mittels eines das Isolierelement (130) rückstellelastisch komprimierenden Einschubdrucks.
e) Aufbau von gegen den Einschubdruck wirkenden Rückstellkräften durch das Isolierelement (130).
f) Durchstoßen der Ausnehmung (139) durch die Rasthaken (120) und Hinterrasten der Rasthaken (120) an der Unterseite des zweiten Bauteils (134).

## Claims

1. Fixing means (110)
- having a shaft (112),
- with a shaft head (116) disposed at one shaft end,
- the shaft head (116) having a wider diameter than the shaft (112),
- the fixing means (110) being provided as a means of fitting two components (133, 134) to one another, in particular for fitting a circuit board (135) provided with an LED to a heat dissipating lamp component (136),
- and the shaft (112) can be inserted through an orifice (138) of a first component (133) and the shaft head (116) is provided so as to sit in at least indirect contact on the first component (133),
- and the shaft (112) can be fitted in a cut-out (139) of a second component (134),
- and the shaft (112) can be at least frictionally anchored in the cut-out (139) of the second component (134) **characterised in that**
- the fixing means (110) is provided with an insulating element (130) which is provided for fitting between the shaft head (116) and the first component (133) and is suitable for preventing a contact between the shaft head (116) and first component (133),
- the fixing means (110) is provided with a clamping element which is suitable for clamping the first component (133) against the second component (134) by the shaft head (116),
- the insulating element is made from an elastically rebounding material and serves as a clamping element,
- the shaft (112) has diameter-widening retaining parts in the form of latch hooks (120) which are able to establish a positive connection with the second component (134),
- the free end (114) of at least one shaft wing (113) is shaped and forms a support element which is supported on the other shaft wing (113),
- the support element holds the shaft wing (113) rigidly in a normal position in which the latch hooks (120) protrude beyond an internal radius r and widen the circumference.

2. Fixing means (110) as claimed in claim 1, **characterised in that** the insulating element is made from an electrically non-conducting material.

3. Fixing means (110) as claimed in claim 1 or 2, **characterised in that** the fixing means (110) is made frommetal.

4. Fixing means (110) as claimed in one of the preceding claims, **characterised in that** the insulating element (130) has an opening in which the shaft (112) of the fixing means (110) is inserted.

5. Fixing means (110) as claimed in one of the preceding claims, **characterised in that** the shaft (112) is formed by two parallel shaft wings (113).

6. Fixing means (110) as claimed in claim 1, **characterised in that** the two shaft wings (113) respectively bear a support element and the support elements are supported against one another.

7. Fitting of a fixing means (110) as claimed in one of claims 1 to 6, a first component (133) and a second component (134), wherein the shaft head (116) lies on an insulating element (130), the insulating element (130) lies on the first component (133) and the first component (133) lies on the second component (134), **characterised in that** a clamping element (140) is supported on the shaft head (116) and applies a mutual pressing force between the first and the second component (133, 134).

8. Fitting as claimed in claim 7 using a fixing means (110) as claimed in claim 1, **characterised in that** the insulating element (130) is clamped against the first component (133) by the fixing means (110) and the rebounding force thus induced applies the pressing force between the first and the second component (133, 134).

9. Method of fitting two components (133, 134) to one another, the first component (133) having an orifice (138) and the second component (134) being provided with a cut-out (139), by means of a fixing element as claimed in one of claims 1 to 6, comprising the following method steps:
a) placing the components (133, 134) one on top of the other so that the orifice (138) and the cut-out (139) are aligned with one another,
b) inserting the fixing means (110) comprising the retaining clamp (111) and insulating element (130) in the insertion direction (x) through the orifice (138), with its free shaft end (114) leading, into the cut-out (139) until the insulating element (130) is seated on the first component (133),
c) sliding the latch hooks (120) on edges of the orifice (138) and cut-out (139) and elastically moving the latch hooks (120) into an interior (117) of the fixing element (110),
d) continuing the insertion movement in the insertion direction (x) by means of an insertion pressure elastically compressing the insulating element (130),
e) increasing rebounding forces opposing the insertion pressure by means of the insulating element (130),
f) penetrating the cut-out (139) by means of the latch hooks (120) and latching the latch hooks (120) against the bottom face of the second component (134).

## Revendications

1. Moyen de fixation (110)
- avec une tige (112),
- avec une tête de tige (116) disposée au niveau d'une extrémité de tige,
- la tête de tige (116) étant élargie en diamètre par rapport à la tige (112),
- le moyen de fixation (110) étant prévu pour disposition de deux composants (133, 134) l'un près de l'autre, en particulier pour disposition d'une carte de circuits imprimés (135) munie d'une DEL, au niveau d'un composant lumineux (136) dissipant la chaleur,
- dans lequel la tige (112) peut être introduite à travers une percée (138) d'un premier composant (133) et la tête de tige (116) est prévue pour au moins un support indirect sur le premier composant (133),
- et dans lequel la tige (112) peut être disposée dans un évidement (139) d'un deuxième composant (134),
- et dans lequel la tige (112) peut être ancrée au moins par friction dans l'évidement (139) du deuxième composant (134),
**caractérisé en ce que** :
- le moyen de fixation (110) est muni d'un élément isolant (130), lequel pour disposition est prévu entre la tête de tige (116) et le premier composant (113) et est adapté pour éviter un contact entre la tête de tige (116) et le premier composant (133),
- le moyen de fixation (110) est muni d'un élément de serrage, lequel convient pour serrer le premier composant (133) contre le deuxième composant (134) sur la tête de tige (116),
- l'élément isolant est composé de matériau résilient et sert d'élément de serrage,
- la tige (112) présente des parties de maintien élargissant le diamètre, en forme de crochets de verrouillage (120) qui peuvent former une liaison en complémentarité de forme avec le deuxième composant (134),
- l'extrémité libre (114) d'au moins une lame de tige (113) est façonnée et forme un élément de support, lequel s'appuie sur l'autre lame de tige (113),
- l'élément de support maintient de manière fixe les lames de tige (113) dans une position normale, dans laquelle les crochets de verrouillage (120) font saillies en s'élargissant vers la périphérie sur un rayon intérieur r.

2. Moyen de fixation (110) selon la revendication 1, **caractérisé en ce que** l'élément isolant est composé d'un matériau non conducteur électriquement.

3. Moyen de fixation (110) selon la revendication 1 ou 2, **caractérisé en ce que** le moyen de fixation (110) est en métal.

4. Moyen de fixation (110) selon l'une des précédentes revendications, **caractérisé en ce que** l'élément isolant (130) présente une ouverture de passage, à travers laquelle la tige (112) du moyen de fixation (110) est guidée.

5. Moyen de fixation (110) selon l'une des précédentes revendications, **caractérisé en ce que** la tige (112) est formée de deux lames de tige (113) parallèles.

6. Moyen de fixation (110) selon la revendication 1, **caractérisé en ce que** les deux lames de tige (113) portent respectivement un élément de support et les éléments de support s'appuient l'un près de l'autre.

7. installation d'un moyen de fixation (110) selon l'une des revendications 1 à 6, d'un premier composant (133) et d'un deuxième composant (134), la tête de tige (116) reposant sur un élément isolant (130), l'élément isolant (130) sur le premier composant (133) et le premier composant (133) sur le deuxième composant (134), **caractérisée en ce qu'**un élément de serrage (140) s'appuie au niveau de la tête de tige (116) et applique une force de pression réciproque entre le premier et le deuxième composants (133, 134).

8. installation suivant la revendication 7 en utilisant un moyen de fixation (110) selon la revendication 1, **caractérisée en ce que** l'élément isolant (130) du moyen de fixation (110) est contraint contre le premier composant (133) et **en ce que** la force de rappel ainsi induite applique la force de pression entre le premier et le deuxième composants (133,134).

9. Procédé pour l'installation de deux composants (133, 134) l'un près de l'autre, le premier composant (133) présentant une percée (138) et le deuxième composant (134) étant muni d'un évidement (139), au moyen d'un élément de fixation selon l'une des revendications 1 à 6, avec les étapes de procédé suivantes :
a) installation des composants (133, 134) l'un sur l'autre, la percée (138) et l'évidement (139) étant alignés ensemble,
b) mise en oeuvre du moyen de fixation (110) composé d'agrafe de retenue (111) et d'élément isolant (130), dans la direction d'insertion (x), à travers la percée (138), avec son extrémité de tige (114) libre, en premier, dans l'évidement (139) jusqu'au positionnement de l'élément isolant (130) sur le premier composant (133),
c) glissement des crochets de verrouillage (120) au niveau des bords de la percée (138) et de l'évidement (139) et déplacement rappelé élastiquement des crochets de verrouillage (120) dans un espace intérieur (117) de l'élément de fixation (110),
d) poursuite du mouvement d'insertion dans la direction d'insertion (x), au moyen d'une pression d'insertion, à rappel élastique, comprimant l'élément isolant (130),
e) création de forces de rappel agissant contre la pression d'insertion par l'élément isolant (130),
f) passage de l'évidement (139) par les crochets de verrouillage (120) et enclenchement par l'arrière des crochets de verrouillage (120) au niveau du côté inférieur du deuxième composant (134).
